Europäisches Patentamt

European Patent Office

Office européen des brevets

(19)

(11) Veröffentlichungsnummer: **0 050 824**
**B 1**

(12) # EUROPÄISCHE PATENTSCHRIFT

(45) Veröffentlichungstag der Patentschrift:
04.06.86

(21) Anmeldenummer: 81108541.4

(22) Anmeldetag: 20.10.81

(51) Int. Cl.⁴: **H 05 K 13/08,** H 05 K 13/00,
**B 65 B 15/04,** H 05 K 13/02

(54) **Prüfvorrichtung.**

(30) Priorität: 25.10.80 DE 3040392

(43) Veröffentlichungstag der Anmeldung:
05.05.82 Patentblatt 82/18

(45) Bekanntmachung des Hinweises auf die Patenterteilung:
04.06.86 Patentblatt 86/23

(84) Benannte Vertragsstaaten:
AT BE CH FR GB IT LI LU NL SE

(56) Entgegenhaltungen:
DE - A - 2 530 990
DE - A - 2 740 231
US - A - 4 003 413

(73) Patentinhaber: Sillner, Georg, Buchenstrasse 23,
D-8411 Zeitlarn (DE)

(72) Erfinder: Sillner, Georg, Buchenstrasse 23,
D-8411 Zeitlarn (DE)

(74) Vertreter: Wasmeier, Alfons, Dipl.-Ing. et al,
Postfach 382 Greflingerstrasse 7, D-8400 Regensburg
(DE)

ACTORUM AG

## Beschreibung

Die Erfindung bezieht sich auf eine Vorrichtung zum Feststellen des Vorhandenseins von auf Trägerstreifen fortlaufend aufgegurteten elektrischen Bauteilen mit mindestens zwei parallel zueinander verlaufenden Elementen, und auf das Prüfen der einwandfreien Positionierung der Elemente.

Zum rationellen und automatischen Bestücken gedruckter Schaltungen ist es erforderlich, dass die für die Schaltung benötigten Bauteile auf Trägerstreifen aufgegurtet sind. Hierzu ist es notwendig, dass die Position der Bauteile und die Abstandsmasse der Anschlussdrähte zum Trägerstreifen exakt sind, da nur Bauteile mit exakter Positionierung von dem Bestückautomat einwandfrei verarbeitet werden können. Die Industrie fordert eine Fehlerhäufigkeit von unter 10 ppm (parts per million). Um diese extreme Anforderung erfüllen zu können, ist eine 100%ige Kontrolle unerlässlich, fehlerhafte Teile müssen erkannt und ausgeschieden werden. Bisher war nur eine stichprobenartige Prüfung möglich; damit ist eine relativ hohe Fehlerquote vorgegeben.

Zum Stand der Technik wird auf folgende Druckschriften verwiesen: DE-A-2 530 990, GB-A-1 399 357 und US-A-4 003 413.

Aufgabe der Erfindung ist es, diese Prüfung selbsttätig mit einer Vorrichtung vorzunehmen und damit eine absolute einwandfreie Begurtung sicherzustellen.

Dies wird gemäss der Erfindung mit einer Vorrichtung erreicht, die gekennzeichnet ist durch

a) eine erste Prüfstation, die das Vorhandensein der Bauteile und einzelner Elemente hiervon feststellt,

b) eine zweite Prüfstation, die in Bewegungsrichtung des Trägerstreifens auf die erste Prüfstation folgt und die eine senkrecht zur Gurtebene bewegbare Prüflehre aufweist, die sich an einem Element des Bauteiles zentriert und bei fortschreitendem Hub der Prüfbewegung die Masshaltigkeit der anderen Elemente abfragt, und

c) eine in zwei zueinander senkrechten Ebenen schwenkbare Anordnung der Prüflehre, bei deren Auslenkung ein Fehlersignal erzeugt wird.

Weitere Merkmale der Erfindung sind Gegenstand der Unteransprüche.

Die erfindungsgemässe Vorrichtung orientiert sich an einem Anschlussdraht und fragt bei fortschreitendem Hub die weiteren Drähte auf einwandfreie Positionierung ab. Dabei wird die Prüfvorrichtung während des Stillstands des im Takt bewegten Gurtes senkrecht zur Gurtebene in Prüfposition bewegt. Bei einer speziellen Ausführungsform der Erfindung wird die Prüflehre zur Durchführung des Prüfvorganges so gegen den zu prüfenden Bauteil bewegt, dass die zu messenden Elemente des Bauteiles bei einwandfreier Positionierung in die Prüföffnungen der Prüflehre zu liegen kommen, bei nicht einwandfreier Positionierung jedoch die Prüflehre ausgelenkt wird.

Mit der erfindungsgemässen Vorrichtung wird festgestellt, ob die auf dem Trägerstreifen lückenlos in gleichem Abstand aufgegurteten Bauteile unter Berücksichtigung eines in der Vorrichtung vorgegebenen Toleranzpegels eine einwandfreie Position eingenommen haben oder nicht; bei Feststellung einer fehlerhaften Positionierung wird der Trägerstreifen stillgesetzt und das fehlerhafte Bauteil kann entfernt werden. Zweckmässigerweise wird der Prüfvorgang gleichzeitig mit dem Lochen des Trägerstreifens durchgeführt, so dass die jeweilige Lochstelle bzw. Perforation, die zum Transportieren des begurteten Trägerstreifens dient, der Bezug für die durchzuführende Prüfung ist. An einer der Prüfstation vorgelagerten Prüfstelle wird vorab festgestellt, ob das Bauteil und die Anschlussdrähte vorhanden sind. Dies geschieht beispielsweise durch elektrische Kontaktgabe. Das Lochen und Prüfen an der gleichen Stelle gewährleistet, dass keine zusätzliche Ausrichtung des Trägerstreifens in bezug auf die Prüfstelle erforderlich ist.

Nachstehend wird die Erfindung in Verbindung mit der Zeichnung anhand eines Ausführungsbeispieles erläutert. Es zeigen:

Fig. 1 eine schematische Darstellung eines kurzen Abschnittes eines begurteten Trägerstreifens;

Fig. 2 eine Aufsicht auf die erfindungsgemässe Vorrichtung,

Fig. 3 eine Seitenansicht der Vorrichtung nach Fig. 2, teilweise im Schnitt,

Fig. 4 eine Vorderansicht der Vorrichtung nach Fig. 2,

Fig. 5 eine Schnittansicht längs der Linie A—B der Fig. 2,

Fig. 6 eine Schnittansicht längs der Linie C–D der Fig. 3,

Fig. 7 eine schematische Darstellung der Wirkungsweise der Prüfvorrichtung für ein elektrisches Bauteil mit drei Anschlussdrähten,

Fig. 8 eine schematische Darstellung der Prüfvorrichtung für ein Bauteil mit zwei Anschlussdrähten.

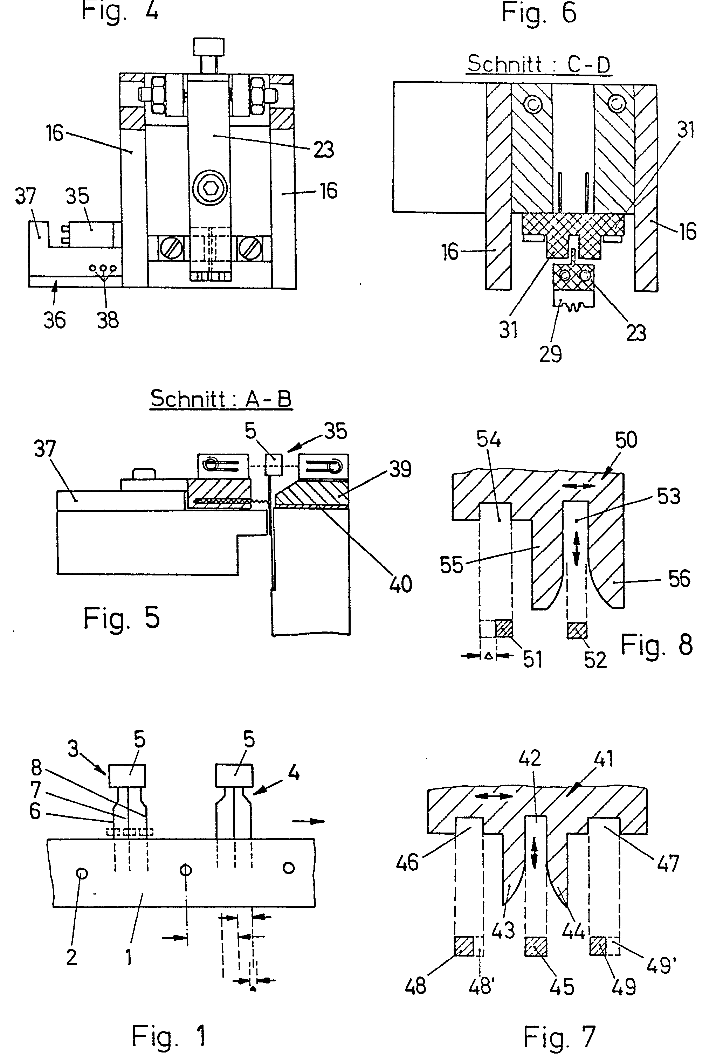

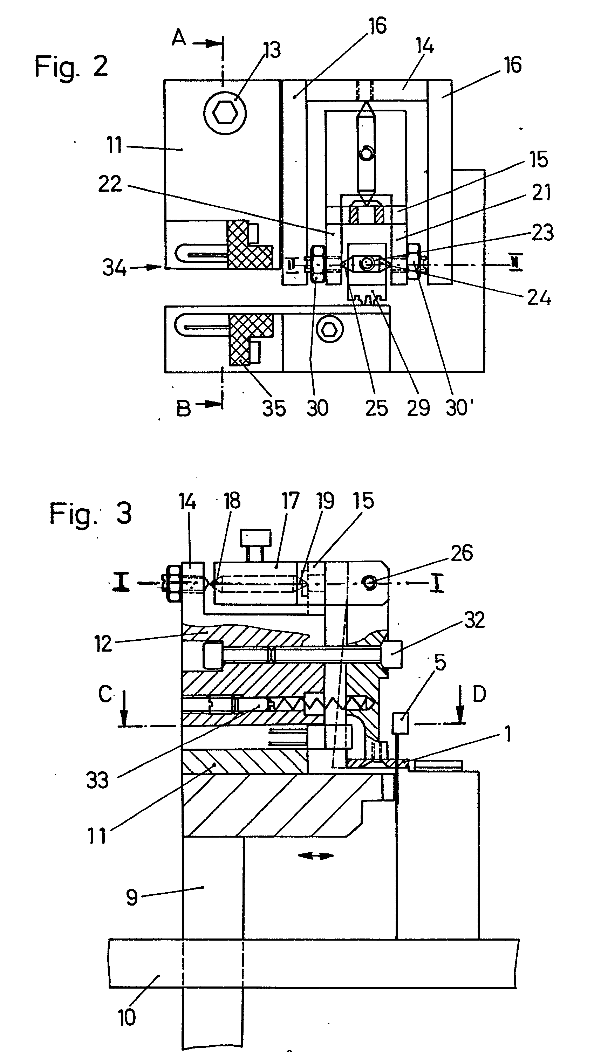

Fig. 1 zeigt einen begurteten Trägerstreifen 1 (Gurtband) mit kreisförmigen, etwa auf der Mittellinie des Streifens in gleichem Abstand gestanzten (dem Bandtransport dienenden) Perforationen 2 und zwei benachbarten, im Trägerstreifen 1 befestigten elektrischen Bauelementen 3, 4 gleicher Ausführung, die jeweils zwischen zwei benachbarten Perforationen 2 in gleichem Abstand voneinander im Trägerstreifen aufgereiht sind. Jedes dieser Bauelemente besteht aus der eigentlichen Elementeinheit 5 sowie drei Anschlussleitern 6, 7, 8, wobei die beiden Aussenleiter 6, 8 in gleichem Abstand vom Mittelleiter 7 entfernt am Trägerstreifen befestigt sind. Für eine einwandfreie Betriebsweise des bestückten Trägerstreifens im Rahmen der bei der Verarbeitung einzuhaltenden Dimensionen bzw. Abstände ist der jeweilige Abstand des Mittelleiters zum linken und zum rechten Leiter sowie der Abstand des Mittelleiters zur Lochmitte der beiden benachbarten Perforationen entscheidend. Für die Durchführung der Prüfung dieser Dimensionen mit der erfindungsgemässen Vorrichtung und eine einwandfreie Positionierung ist ausschlaggebend, dass festgestellt wird, ob der Mittelleiter (Fig. 7) bzw. einer der beiden Leiter (Fig. 8) exakt auf den Mittelpunkt der Lochstelle ausgerichtet ist und die Aussenleiter im richtigen Abstand zum Mittelleiter angeordnet sind, wobei ein bestimmter Toleranzbereich zugelassen wird, der durch die Messvorrichtung berücksichtigt wird. Die mittlere Öffnung bzw. eine der beiden Öffnungen dient dabei als Zentrieröffnung für den zugeordneten Anschlussdraht. Es ist ferner zweckmässig, vor der eigentlichen Prüfung festzustellen, ob alle drei Anschlussleiter 6, 7, 8 und die Elementeinheit 5 überhaupt bzw. in der annähernd richtigen Position vorhanden sind. Dies wird durch das Fehlen oder Vorhandensein einer elektrischen Kontaktgabe bzw. durch Ansprechen einer Lichtschranke erreicht, während der eigentliche Prüfvorgang zur Ermittlung des exakten Abstandes der Anschlussleiter (im Rahmen der zugelassenen Toleranz) untereinander und zu den Lochstellen durch Prüfen mit Hilfe der Prüfvorrichtung erfolgt.

Diese Prüfvorrichtung weist ein Grundbauteil 9 auf, das auf dem Maschinenrahmen 10 einer Begurtmaschine senkrecht zum Gurtband 1 hin- und herbewegbar befestigt ist. Am Grundbauteil 9 ist über einen Flansch 11 der Geräteblock 12, z.B. mittels Schraubverbindung 13, befestigt. Der Geräteblock 12 besitzt in seinem oberen Bereich eine Rückwand 14, eine Vorderwand 15 und Seitenwände 16, 16. Vorder- und Rückwand nehmen jeweils die Lagerung 18, 19 (Spitzenlagerung) eines um seine Längsachse I–I verschwenkbaren horizontalen Armes 17 auf, der die Form einer Gabel besitzt, deren Zinken 21, 22 die unterbrochene Vorderwand 15 umschliessen und über die Vorderwand hinaus verlängert sind. Am Vorderende des Armes 17 bzw. an dessen beiden Zinken ist ein vertikaler Prüfhebel 23 gelagert, der frei nach abwärts steht; die Lagerstellen 24, 25 in der Achse II–II sind z.B. als Spitzenlager ausgebildet. Damit ist der Prüfhebel 23 in der Lage, sich um eine Schwenkachse 26 (II–II) entsprechend der Drehung des Armes 17 in der Zeichenebene (Fig. 3) zu verdrehen. Das Ausmass dieser Verdrehung wird durch Anschläge begrenzt, die an den Seitenwänden 16, 16 einstellbar über Schrauben 30, 30' befestigt sind. Durch die Begrenzung der Verschwenkbarkeit nach der Seite wird die Toleranz für die Genauigkeit der Lage der zu prüfenden Anschlussdrähte festgelegt.

Der Prüfhebel 23 nimmt an seinem unteren Ende eine Prüflehre 29 auf, die im einzelnen in Fig. 7 bzw. Fig. 8 dargestellt ist. Diese Prüflehre ist zusammen mit der gesamten Prüfvorrichtung senkrecht zur Gurtbandebene hin- und herbewegbar, so dass nach jedem Bewegungsschritt des Trägerstreifens 1 die Prüflehre in die Zwischenräume der Anschlussdrähte eingefahren wird, falls die Anschlussdrähte einwandfrei positioniert sind. Ist jedoch einer der Anschlussdrähte beispielsweise verbogen, ist das Einführen der Prüflehre nicht möglich und der Prüfhebel 23 wird nach rückwärts ausgelegt. Dabei kommt die Prüflehre 29 in den Wirkungsbereich einer Lichtschranke 31, die ein Signal erzeugt, das eine Weiterschaltung des Gurtbandes 1 unterbindet. Anstelle einer Photozellenanordnung kann jedoch auch eine andere Wegabfragevorrichtung mechanischer, elektrischer oder elektronischer Art Verwendung finden. Die Bewegung des Prüfhebels 23 in der entgegengesetzten Richtung, also nach vorne, wird durch einen Anschlag 32 begrenzt, der an einem die Vorrichtung durchsetzenden, ggfs. verstellbaren Schaft befestigt ist. Weiterhin ist ein Federstift 33 vorgesehen, der parallel zum Anschlagstift 32 verläuft und der den Prüfhebel 23 gegen den Anschlag 32 drückt, also eine Vorspannung für den Prüfhebel 23 bewirkt.

In Gurtbandbewegungsrichtung vor der beschriebenen Prüfvorrichtung ist eine Prüfstation 34 vorgesehen, die ein oder zwei Lochstellen vor dem eigentlichen Prüfvorgang der Prüflehre 29 eine Prüfung auf das Vorhandensein der Anschlussdrähte 6, 7, 8 sowie der Elementeinheit 5 vornimmt. Die Prüfstation weist bei dem dargestellten Ausführungsbeispiel eine Lichtschranke 35 zum Feststellen des Vorhandenseins der Elementeinheit 5 auf, zwischen der das Gurtband 1 durchläuft. Ferner ist zum Feststellen des Vorhandenseins der Anschlussdrähte 6, 7, 8 auf beiden Seiten des Gurtbandes eine Kontaktanordnung 36 vorgesehen, die aus einem Isolierblock 37 auf der einen Seite des Gurtbandes und aus Andrückfederelementen 38 besteht, die den Anschlussdrähten zugeordnet sind. Die Federelemente geben bei Vorhandensein der Anschlussdrähte einen elektrischen Kontakt, während ein solcher Kontakt nicht zustande kommt, wenn das betreffende Federelement fehlt oder soweit ausgebogen ist, dass es nicht im Einflussbereich des Federelementes liegt. Die Kontaktanordnung 36 mit den Federelementen 38 ist auf einer Halterung 39 angebracht; die Lichtschranke 35 sitzt unter Zwischenschaltung einer Isolierschicht 40 auf dem Maschinengestell auf.

Die Fig. 7 und 8 zeigen jeweils schematisch die Ausgestaltung der Prüflehre 29 für die Bauteile mit drei bzw. für zwei Anschlussdrähte. Die Prüflehre 41 ist in bezug auf die linke und rechte Seite symmetrisch ausgebildet und weist eine mittlere Aussparung 42 sowie daran anschliessende und diese Aussparung formende Ansätze 43 und 44 auf. Diese mittlere Aussparung dient zur Aufnahme bzw. Zentrierung des mittleren Anschlussdrahtes 45 und ist in ihrer Breitenabmessung nur geringfügig grösser als der Breitenabmessung des Anschlussdrahtes 45 entspricht.

Links und rechts von den Ansätzen 43 und 44 sind symmetrische Aussparungen 46 und 47 vorgesehen, die einen Toleranzbereich für die beiden äusseren Anschlussdrähte 48 und 49 haben, was durch die Bezugszeichen 48 und 48' bzw. 49' und 49 zum Ausdruck gebracht ist. Bei der Prüflehre nach Fig. 8, die mit 50 bezeichnet ist, werden Bauteile mit zwei Anschlussdrähten 51 und 52 gemessen. Die Aussparungen 53 und 54 sowie die Ansätze 55 und 56 sind hierbei unsymmetrisch gestaltet, wobei die Aussparung 53 der Aussparung 42 nach Fig. 7 entspricht, während die Aussparung 54 der Aussparung 46 nach Fig. 7 entspricht. In Fig. 7 wie in der Fig. 8 ist schematisch durch Pfeile angedeutet, wie die Auslenkung der Prüflehre 41 bzw. 50 während des Prüfvorganges erfolgt, wenn eine fehlerhafte Positionierung der Anschlussdrähte gegeben ist.

## Patentansprüche

1. Vorrichtung zum Feststellen des Vorhandenseins von auf Trägerstreifen fortlaufend aufgegurteten elektrischen Bauteilen, die mindestens zwei parallel zueinander verlaufende, von dem Bauteil ausgehende Elemente aufweisen, sowie zum Feststellen der einwandfreien Positionierung dieser Bauteile bzw. dieser Elemente, gekennzeichnet durch

a) eine erste Prüfstation (34–38), die das Vorhandensein der Bauteile (5) und der einzelnen Elemente (6–8) feststellt,

b) eine zweite Prüfstation (11–31), die in Bewegungsrichtung des Trägerstreifens (1) auf die erste Prüfstation folgt und die eine senkrecht zur Gurtebene bewegbare Prüflehre (29) aufweist, die sich an einem Element (6–8) des Bauteiles (5) zentriert und bei fortschreitendem Hub der Prüfbewegung die Masshaltigkeit der anderen Elemente abfragt, und

c) eine in zwei zueinander senkrechten Ebenen schwenkbare Anordnung der Prüflehre (29), bei deren Auslenkung ein Fehlersignal erzeugt wird.

2. Vorrichtung nach Anspruch 1, dadurch gekennzeichnet, dass die parallelen Elemente der elektrischen Bauteile mindestens zwei parallel zueinander verlaufende Anschlussdrähte sind.

3. Vorrichtung nach Anspruch 1 oder 2, dadurch gekennzeichnet, dass eine Erkennungsvorrichtung (31) vorgesehen ist, die mit der Prüflehre (29) zusammenwirkt, und die bei einer Auslenkung der Prüflehre durch eines oder mehrere Elemente (6–8) in fehlerhafter Position ein Signal erzeugt.

4. Vorrichtung nach Anspruch 3, dadurch gekennzeichnet, dass die Erkennungsvorrichtung (31) eine Fotozellenanordnung oder eine elektrische oder elektronische Wegabfragevorrichtung ist.

5. Vorrichtung nach Anspruch 1, dadurch gekennzeichnet, dass die Prüflehre (29) auf einem vertikalen Prüfhebelarm (23) angebracht ist, der in einer zur Gurtebene senkrechten Ebene auf den Gurt (1) zu und von diesem weg verschwenkbar ist, und der um einen rechtwinkelig dazu angeordneten, um eine horizontale Achse drehbar gelagerten Schwenkarm (17) verschwenkbar ist.

6. Vorrichtung nach einem der Ansprüche 1–5, dadurch gekennzeichnet, dass die Prüfbewegung der Prüflehre (29) wahlweise während des Stillstandes des im Takt bewegten Gurtes (1) oder im Takt des Stanzens der Perforationslöcher (2) im Gurtband (1) erfolgt.

7. Vorrichtung nach einem der Ansprüche 1–6, dadurch gekennzeichnet, dass die Prüflehre (29) an der gleichen Stelle des Gurtbandes wie die Stanzvorrichtung, jedoch um einen halben Teilungsschritt (in Gurtbewegungsrichtung) hinter der Stanzvorrichtung angeordnet ist, und dass Stanzvorrichtung und Prüfvorrichtung gleichzeitig miteinander bewegt werden.

8. Vorrichtung nach einem der Ansprüche 1–7, dadurch gekennzeichnet, dass die erste Prüfstation mindestens eine Prüfstelle vor der zweiten Prüfstation vorgesehen ist.

9. Vorrichtung nach einem der Ansprüche 1–8, dadurch gekennzeichnet, dass das Feststellen des einwandfreien Vorhandenseins der parallelen Elemente durch elektrische Kontaktgabe erfolgt.

10. Vorrichtung nach einem der Ansprüche 1–8, dadurch gekennzeichnet, dass das einwandfreie Vorhandensein des Bauteiles und/oder der parallelen Elemente durch eine Gabellichtschranke erfolgt.

11. Vorrichtung nach einem der Ansprüche 2–10, dadurch gekennzeichnet, dass die Prüflehre (29; 41; 50) eine Zentrieröffnung (42; 53), deren Breite die Breite eines Anschlussdrahtes (6–8) nur wenig übersteigt, und mindestens eine im seitlichen Abstand angeordnete Öffnung (46, 47; 54), deren Breite um einen vorgegebenen Toleranzbereich grösser ist als die Breite eines zur Aufnahme vorgesehenen Anschlussdrahtes (6–8), aufweist.

## Claims

1. Device for determining the existence of electrical components continuously arranged on a supporting strap, which components have at least two elements extending parallel to each other from the component, and for determining the correct positioning of said components or alternatively said elements, characterised by

a) a first test station (34–38), which determines the presence of the components (5) and the individual elements (6–8),

b) a second test station (11–31), which succeeds the first test station in the direction of movement of the supporting strap (1) and which has a reference gauge (29) movable vertically to the plane of the strap, which gauge centers on an element (6–8) of the component (5) and with increasing shift of the testing movement inquires accuracy to size of the remaining elements, and

c) arranging the reference gauge (29) pivotably in two planes vertical to each other, a deflection of the gauge generating an error signal.

2. Device according to claim 1, characterised in that the parallel elements of the electrical components are at least two connecting wires extending parallel to each other.

3. Device according to claim 1 or 2, characterised in that identification means (31) are provided, which cooperate with the reference gauge (29) and which with a deflection of the reference gauge in view of one or several elements (6–8) in a faulty position generate a signal.

4. Device according to claim 3, characterised in that the identification means (31) are a photo cell arrangement or electrical or electronic path interrogating means.

5. Device according to claim 1, characterised in that the reference gauge (29) is arranged on a vertical lever arm (23), which is pivotable in a plane vertical to the strap plane towards and away from the strap (1), and which is pivotable around a pivot arm (17) rotatably supported around a horizontal axis rectangular thereto.

6. Device according to one of claims 1–5, characterised in that the testing movement of the reference gauge (29) alternatively is made during the standstill of the stepwise moved strap (1) or in time with punching the perforation holes (2) into the strap (1).

7. Device according to one of claims 1–6, characterised in that the reference gauge (29) is provided at the same position of the strap as the punch means, however, half the partition step (in the direction of movement of the strap) behind the punch means, and that the punch means and the reference gauge are moved together simultaneously.

8. Device according to one of claims 1–7, characterised in that the first test station is provided at least one test position upstream of the second test station.

9. Device according to one of claims 1–8, characterised in that determining the correct presence of the parallel elements is made by electrical contact making.

10. Device according to one of claims 1–8, characterised in that the correct presence of the component and/or the parallel elements is provided by a fork-type light barrier.

11. Device according to one of claims 2–10, characterised in that the reference gauge (29; 41; 50) has at least one centering aperture (42, 53) the width of which only is slightly larger than the width of a connecting wire (6–8), and a least one laterally displaced aperture (46, 47; 54), the width of said aperture being larger for a predetermined tolerance than the width of a connecting wire (6–8) to be taken up.

## Revendications

1. Dispositif pour la constatation de la présence de composants électriques mis de façon continue sur des bandes de support, ces composants présentant au moins deux éléments parallèles qui en partent, et pour la constatation du parfait positionnement de ces composants ou de ces éléments, caractérisé par

a) un premier poste de contrôle (34 à 38) qui constate la présence des composants (5) et des différents éléments (6 à 8),

b) un deuxième poste de contrôle (11 à 31) qui succède au premier dans le sens de déplacement de la bande de support (1) et qui présente une jauge de contrôle (29) mobile perpendiculairement au plan de la bande qui se centre sur un des éléments (6 à 8) du composant (5) et, quand la course du mouvement de contrôle progresse, interroge sur l'exactitude des dimensions des autres éléments, et

c) un montage avec possibilité de rotation dans deux plans perpendiculaires de la jauge de contrôle (29), lors de la déviation de laquelle est produit un signal d'erreur.

2. Dispositif selon la revendication 1, caractérisé en ce que les éléments parallèles des composants électriques sont au moins deux fils de connexion parallèles.

3. Dispositif selon l'une des revendications 1 et 2, caractérisé en ce qu'il est prévu un dispositif de reconnaissance (31) qui coopère avec la jauge de contrôle (29) et produit un signal en cas de déviation de celle-ci par un ou plusieurs éléments (6 à 8) en mauvaise position.

4. Dispositif selon la revendication 3, caractérisé en ce que le dispositif de reconnaissance (31) est un dispositif à cellule photo-électrique ou un dispositif électrique ou électronique d'interrogation de course.

5. Dispositif selon la revendication 1, caractérisé en ce que la jauge de contrôle (29) est montée sur un bras de levier de contrôle vertical (23) qui peut pivoter dans un plan perpendiculaire au plan de la bande (1) pour venir sur celle-ci et s'en écarter et qui peut pivoter autour d'un bras tournant (17) placé perpendiculairement audit bras de levier et monté tournant autour d'un axe horizontal.

6. Dispositif selon l'une des revendications 1 à 5, caractérisé en ce que le mouvement de contrôle de la jauge de contrôle (29) a lieu au choix pendant un arrêt de la bande (1) mue en cadence, ou au rythme de l'exécution des trous (2) dans la bande (1).

7. Dispositif selon l'une des revendications 1 à 6, caractérisé en ce que la jauge de contrôle (29) est placée au même endroit de la bande que le dispositif de perforation, mais un demi-pas derrière lui (dans le sens de mouvement de la bande) et en ce que le dispositif de perforation et le dispositif de contrôle sont mus simultanément.

8. Dispositif selon l'une des revendications 1 à 7, caractérisé en ce que le premier poste de contrôle comprend au moins un emplacement de contrôle avant le deuxième poste de contrôle.

9. Dispositif selon l'une des revendications 1 à 8, caractérisé en ce que la constatation de la présence correcte des éléments parallèles se fait par établissement de contact électrique.

10. Dispositif selon l'une des revendications 1 à 8, caractérisé en ce que la constatation de la présence correcte du composant et/ou des éléments parallèles se fait au moyen d'une barrière lumineuse à fourche.

11. Dispositif selon l'une des revendications 2 à 10, caractérisé en ce que la jauge de contrôle (29, 41, 50) présente une ouverture de centrage (42, 53), dont la largeur dépasse un peu la largeur d'un fil de connexion (6 à 8), et au moins une ouverture (46, 47, 54) située à une certaine distance sur le côté dont la largeur est supérieure d'une marge de tolérances fixées à la largeur d'un fil de connexion (6 à 8) qu'elle doit recevoir.

Fig. 4

Fig. 6

Schnitt : C - D

Schnitt : A - B

Fig. 5

Fig. 8

Fig. 1

Fig. 7

0 050 824

Fig. 2

Fig. 3

9